Europäisches Patentamt

European Patent Office

Office européen des brevets

(19)

(11) Publication number: **0 324 596**
**A2**

# EUROPEAN PATENT APPLICATION

(12)

(21) Application number: **89300208.9**

(51) Int. Cl.⁴: **H 05 K 3/00**

(22) Date of filing: **11.01.89**

(30) Priority: **11.01.88 US 142575    18.11.88 US 272974**

(43) Date of publication of application:
**19.07.89 Bulletin  89/29**

(84) Designated Contracting States:
**AT BE CH DE ES FR GB IT LI NL SE**

(71) Applicant: **MORTON THIOKOL, INC.**
**110 North Wacker Drive**
**Chicago Illinois 60606-1560  (US)**

(72) Inventor: **Maligie, William A.**
**26382 Ganiza Street**
**Mission Viejo California 92692  (US)**

**Roos Leo**
**1404 Morning Side Drive**
**Laguna Beach - California 92651  (US)**

**Derrico Gene**
**21891 Ontur**
**Mission Viejo - California 92692  (US)**

(74) Representative: **Bankes, Stephen Charles Digby et al**
**BARON & WARREN 18 South End Kensington**
**London W8 5BU  (GB)**

(54) Method of and apparatus for applying polymeric materials to printed circuits.

(57)    A method of and apparatus for applying a curable dry film of polymeric or heat sensitive material to a specific area of one or both surfaces of a printed circuit board (58) to provide protection from stripping and plating operations during the fabrication thereof involves the use of a hot elastomeric pad (50) backed by a rigid surface (52) for stamping or pressing the dry film of protective material to the surface of the printed circuit board. The configuration of the elastomeric pad, (50), the contacting surface (56) thereof, or the support means therefor allow increased conformity of the dry film of polymeric material with irregularities in the surface of a printed circuit board and precludes the formation of air pockets therebetween. The invention is also applicable to semiconductor wafer fabrication.

CYCLE "DOWN" POSITION

Fig. 5

EP 0 324 596 A2

## Description

## METHOD OF AND APPARATUS FOR APPLYING POLYMERIC MATERIALS TO PRINTED CIRCUITS

This invention relates to the application of heat or photosensitive materials to a printed circuit board or semiconductor wafer for providing protection therefor during the fabrication thereof.

Prior to electroplating or stripping operations in the manufacture of printed circuit boards, it is the current practice in the art to partially cover the surfaces of the circuit boards or other substrates with a masking tape. The masking tape comprises a foil-like carrier that is made of a material such as paper or plastic and a coating of an adhesive material applied to one side of the carrier. The carrier may be self-adhesive or adhered to the circuit board by a pressure or heat activation process.

Such masking tapes serve the purpose of protecting and thereby preserving intact, during plating and stripping operations, predetermined portions of circuit boards. For example, during the plating of gold on the finger-like conductors or "fingers" provided at the edge of a circuit board, the areas which are to be subsequently gold plated are protected from the stripping and plating baths by a pressure sensitive tape commonly known as "platers" tape.

Many problems are encountered in the prior art with the adhesive tape and tape masking process, including the following:

1. The tape is manually applied. This is a cumbersome process that is difficult to automate for varied types of printed circuit boards.

2. Subsequent removal of the tape is by hand-stripping (or mechanical stripping) and generally involves mechanical scrubbing.

3. Hand-stripping of the tape tends to result in numerous defect-causing "nicks" of the printed circuit boards which lower yields by an estimated 5% of the production line. This problem becomes more serious as the width of the conductor lines in the circuit pattern on the printed circuit boards is reduced to 5-8 mils from the older 10-15 mils width.

4. The residual adhesive that is usually left behind is removed by an organic solvent wash. Typically, in printed circuit facilities, several operators are stationed at the end of the gold plating line. Their major function is to manually remove the platers tape and then apply organic solvents in an effort to remove the adhesive residue. Reliability problems may result if all the residue is not removed.

5. The organic solvents required to remove the residual adhesive may cause ionic contamination problems on the surface of the circuit boards and are possibly hazardous to the health of personnel engaged in the handling thereof. There is a movement in U. S. industry which is lobbying for reducing worker contact with organic solvents like MEK, 1,1,1-trichlorethane, industrial alcohols, and methylene chloride because of their potentially adverse health effects.

6. Organic solvents, such as methylene chloride, used to remove the tape residues, can also remove or soften the epoxy resin which is on the surface of the circuit board.

7. Platers tape does not conform well to the circuit trace geometries. As a result, plating and stripping bath chemicals can wick under the tape to cause uneven plating.

8. Plating bath chemicals which wick under the tape can be released in subsequent baths resulting in cross contamination.

9. The adhesive tape process is labor intensive, and therefore, expensive.

Thus, there exists a need and a demand for improvement in the method of and apparatus employed for protecting printed circuit boards, semiconductor wafers, semiconductor lead frames and the like during plating and stripping opertions.

An object of the invention is to provide an improved method of and apparatus for the efficient utilization of a curable polymer or heat sensitive material to provide protection, during the fabrication thereof, to printed circuit boards, semiconductor wafers and semiconductor lead frames.

Another object of the invention is to provide a process and apparatus involving the use of a hot elastomeric pad for applying a curable dry film of polymeric or heat sensitive material to a specific area or areas of each of a plurality of printed circuit boards, which area, in each case, is to be protected from the stripping and plating operations that are involved in the fabrication of the printed circuit boards.

A further object of the invention is to provide an improved process and apparatus involving the use of a hot elastomeric pad backed by a rigid surface for applying with uniform pressure and temperature a dry film of curable polymeric or heat sensitive material to the surface of a substrate, which surface may involve areas of non-planar geometry, thereby providing greater conformation of the polymeric or heat sensitive material to the surface of the substrate.

An additional object of the invention is to provide such an improved process and apparatus including an elastomeric pad that is so characterized as to remove air between the dry film of curable polymeric or heat sensitive material and the surface of the substrate thereby to avoid the occurrence of air pockets therebetween and to facilitate the application of the film to allow selective gold plating.

Still another object of the invention is to provide such an improved process and apparatus that involves an initial single line contact of a planar or non-planar elastomeric surface onto a dry film of curable polymeric or heat sensitive material that is to be attached to the surface of a substrate for preventing air entrapment between the polymeric or heat sensitive material and the surface of the substrate.

An additional object of the invention is to provide a process for applying a curable film of polymeric material to the surface of a workpiece to provide protection for the workpiece during the fabrication thereof, comprising the steps of:

(a) interposing the film of polymeric material between the surface of the workpiece to be protected and the contacting surface of an elastomeric pad backed by a rigid planar surface, and

(b) moving the elastomeric pad into contact with the dry film of polymeric material with the contacting surface of the elastomeric pad being so configured as to provide initial single line contact with the film of polymeric material with the area of contact increasing at a substantially constant rate until the contacting surface of the elastomeric pad is substantially parallel to the surface of the workpiece, whereby a pressure wave is produced that pushes air out from between the film of polymeric material and the surface of the workpiece, which air otherwise could become entrapped between the film of polymeric material and the surface of the workpiece.

A further object of the invention is to provide a method of and apparatus for applying a die/cut dry film of polymer or heat sensitive material to semiconductor wafers for subsequent processing through pattern delineation, etching, and plating.

In accomplishing these and other objectives, the invention involves the use of a hot pressing or stamping apparatus for securing a dry film of polymeric or heat sensitive material onto the surface of a printed circuit board. More specifically, the invention involves the use of a hot pad made of elastomeric material for pressing and securing the film to the board. The elastomeric pad is characterized in providing at a contacting surface thereof a consistent and somewhat uniform pressure to irregular surfaces. This is because the pad is sufficiently soft to act similarly to a fluid providing equal and opposite pressures to the entire surface of the printed circuit board with which the contacting surface thereof comes into contact. As a result, the pad allows a film of polymeric or heat sensitive material to be uniformly coated on uneven surfaces and also provides increased surface conformity.

For preventing air entrapment when applying, that is, laminating, a dry film of polymeric or heat sensitive material to a planar or non-planar substrate surface, the contacting surface of the elastomeric pad is so characterized or positioned with respect to the surface of the substrate as to provide for an initial area of contact of the contacting surface thereof that is substantially less than the contacting surface area, with the area of contact increasing at a constant rate until the contacting surface of the elastomeric pad is parallel to the substrate surface, that is to say, substantially coincides therewith. This procedure allows for a pressure wave to be set up which pushes air out from between the film of polymeric or heat sensitive material and the surface of the substrate. Such air would otherwise become entrapped between the film of polymeric or heat sensitive material and the surface of the substrate.

There is further provided, according to the invention, apparatus which has utility in applying die cut polymeric or heat sensitive film in the form of a dry film onto semiconductor wafers for subsequent processing through pattern delineation, etching and plating, a process by which the semiconductor wafer or chip is attached to points or posts by which the semiconductor is bonded to the printed circuit board.

Specifically, in a process known as wire bonding, chips are diced, the good ones are sorted out, the chips are mounted on a lead frame of some sort and an automatic wire bonder attaches a small wire from each of numerous bonding pads to leads on the lead frame. Wire-like interconnect structures or "bumps" are grown on the wafer before the wafer is diced. Once complete, the wafer is diced and each chip is attached to a lead frame which connects directly to the interconnect bumps. The bumps make the connection to the lead frame.

The portion of the wire bonding process with which the present invention is particularly concerned is the process by which the bumps are grown on the wafer. Typically, a gold film is sputtered on the surface of the wafer to act as an electrode for the plating process. A film of polymeric or heat sensitive material is applied to the wafer with a thickness of 0.8 to 1.5 mils (20 to 38 microns, approximately). This material is then patterned with minimum geometries currently at a four (4) mil (101.6 microns) pitch, that is, with a line two (2) mils (50.8 microns) wide and a two (2) mil (50.8 microns) space. The film of polymeric or heat sensitive material acts as a plating mask and must withstand the temperatures and chemical species associated with gold and tin/lead (Sn/Pb) electroplating baths. The plating process produces the bumps or wire-like interconnect structures. The film of polymeric or heat sensitive material is then cured and developed. Unwanted conductive material is then removed by chemical etching, leaving the interconnect structures or bumps.

The various features of novelty which characterize the invention are pointed out with particularity in the claims annexed to and forming a part of this specification. For a better understanding of the invention, its operating advantages, and specific objects attained by its use, reference is made to the accompanying drawings and descriptive matter in which preferred embodiments of the invention are illustrated.

With this description of the invention, a detailed description follows with reference being made to the accompanying figures of drawing which form part of the specification, in which like parts are designated by the same reference numbers, and of which:

Fig. 1 illustrates an elastomeric pad backed by a rigid surface applying uniform temperature and pressure to the surface of a substrate, which surface, as shown, may be irregular;

Figs. 2, 4 and 6 and respectively associated Figs. 3, 5 and 7 collectively illustrate a method of affixing a dry film of polymeric material to a printed circuit board using the elastomeric pad of Fig. 1;

Figs. 8, 9 and 10 illustrate the operation of a modified configuration of the elastomeric pad of Fig. 1 for precluding the entrapment of air between the film of polymeric material and the surface of the printed circuit board;

Figs. 11, 12 and 13 illustrate the operation of another modified configuration of the elastomeric pad of Fig. 1 for precluding the entrapment of air between the film of polymeric material and the surface of the printed circuit board;

Fig. 14 is a greatly enlarged perspective view, as seen with the aid of a scanning electron microscope, showing the manner in which the dry film polymeric material drapes over and conforms to the configuration of the raised conductive elements on a printed circuit board;

Figs. 15, 16, 17 and 18 are top plan, left side, front, and right side views, respectively, of a laminator embodiment of the invention for applying a dry film of curable polymeric or heat sensitive material to both sides of a printed circuit board for protecting areas or zones of the printed circuit board during the fabrication thereof;

Fig. 19 is a view showing in greater detail upper and lower heated platens of the laminator of Figs. 15-18, as seen from the left side view of Fig. 16;

Fig. 20 illustrates a system of several machine stations that may be employed in the utilization of the present invention for the fabrication of printed circuit boards, semiconductor wafers and semiconductor lead frames;

Fig. 21 is a schematic illustration of an alternative form of apparatus for carrying out the process according to the present invention; and

Figs. 22 and 23 are cross sectional and fragmented plan views, respectively, of a form of dry film that advantageously may be employed in the process and apparatus of the present invention.

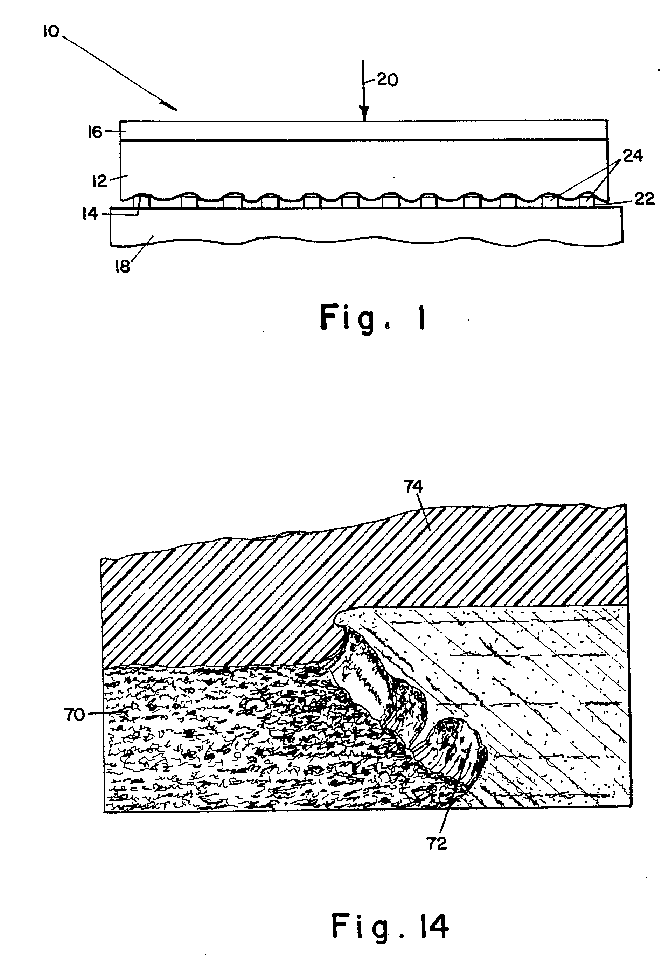

The invention involves, as illustrated in Fig. 1, a hot pressing or stamping member 10, for convenience termed an elastomeric pad, comprising a heated elastomeric pad element 12 having a contacting surface 14 and which is backed by a rigid surface 16 for applying uniform pressure and temperature to a substrate 18 which may have a regular or irregular surface. The pad element 12 may comprise a high temperature rubber such as the product marketed by E. I. du Pont de Nemours & Co. under the trademark VITON and desirably has a hardness in the range of 60 +/- 20 as measured by a durometer.

Backed by the rigid surface 16, which may be made of aluminum, the pad element 12 provides a consistent and somewhat uniform pressure to irregular surfaces with which the contacting surface 14 of pad element 12 may be moved into contact as by an applied force indicated by the arrow 20. This is because the pad element 12 is soft enough to act similarly to a fluid providing equal and opposite pressure to the entire surface area with which the contacting surface 14 thereof comes into contact.

In Fig. 1 a surface 22 of substrate 18 that is positioned to be contacted by the contacting surface 14 of pad element 12 is shown as being irregular. The irregularity in the surface 22 is due to raised elements 24 thereon. Elements 24 represent, although in an exaggerated manner, the raised electrically conductive circuit paths on a printed circuit board.

Upon movement of the contacting surface 14 of pad element 12 into engagement with the surface 22, as indicated in Fig. 1, the contacting surface 14 flows into the spaces between the raised elements 24 and conforms to the geometrical configurations thereof, as indicated by the undulations in the contacting surface 14. The contacting surface 14 of pad element normally, that is when not under pressure, is flat and generally parallel to the surface 22. As a result, substantially equal pressure is exerted in all directions by the contacting surface 14 upon the surface 22 of the substrate and upon the tops and sides of the raised elements 24.

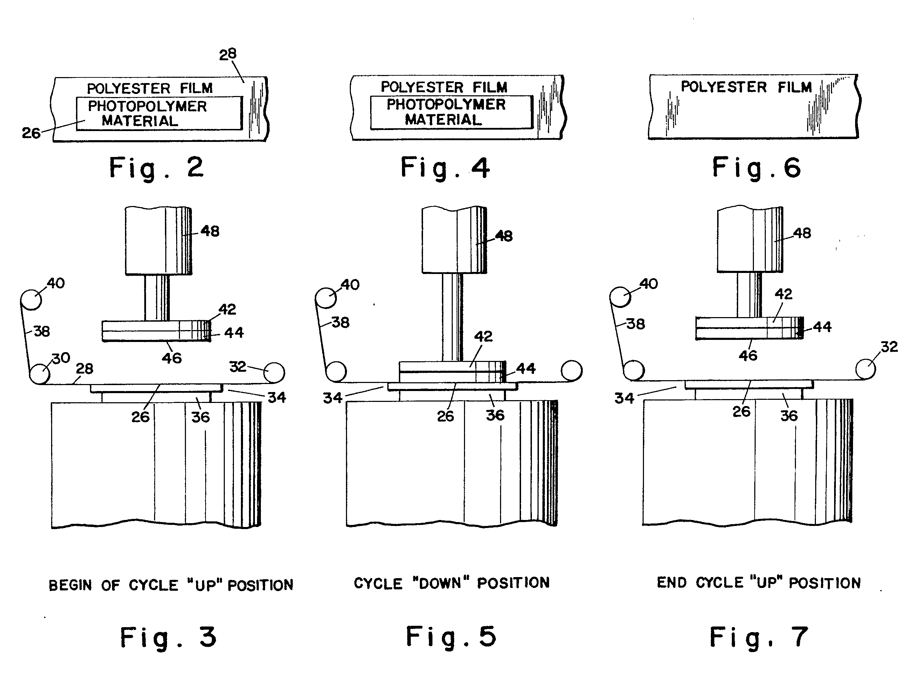

The manner of affixing a curable dry film of polymeric or heat sensitive material to a portion or zone of a printed circuit board to be protected, according to one embodiment of the invention, is illustrated by reference to Figs. 2 through 7. Thus, Fig. 2 shows an area 26 of curable dry film of polymeric or heat sensitive material on a carrier web 28. The carrier web 28 extends, as shown in Fig. 3, from a feed roll 30 of material 26 to a take-up roll 32 and has formed thereon, along the length thereof, a succession of uniformly spaced pieces, islands or areas 26 of the curable film of material, all of which areas 26 may be of the same size and correspond in size to each of the areas of the surfaces of a plurality of printed circuit boards to be protected. An exposed area of the dry film of material 26 is brought into position immediately above, adjacent, and in alignment with a portion of a printed circuit board 34 to be protected, which board 34 rests on a stationary platen 36.

An advantageous process for preparing such a succession of uniformly spaced areas 26 of curable dry film of material on a carrier web 28 is disclosed and claimed in copending application bearing Serial No. 141,815, filed on January 11, 1988 by William A. Maligie, the disclosure of which application, by reference, is incorporated herein.

A particularly advantageous form of curable film of material that may be employed for the film 26 is disclosed in U. S. Patent No. 3,887,450 entitled "PHOTOPOLYMERIZABLE COMPOSITIONS CONTAINING POLYMERIC BINDING AGENTS," granted on June 3, 1975 to Michael N. Gilano and assigned to Morton Thiokol, Inc., the assignee of the present invention. Such film comprises a dry film photopolymer resist and is available commercially, under the trademark "LAMINAR" TA from the Dynachem Division of Morton Thiokol, Inc. The dry film of photopolymer resist is characterized in that it can be readily developed in a developer solution that may be aqueous, semi-aqueous or pure solvent to yield a resist which when exposed to actinic light is impervious to conventional plating solutions but which is aqueous strippable.

As manufactured, the dry film photopolymer resist is in the form of a thin dry film or coating of polymeric material on a carrier or polyester support web. Although tacky, the dry film is "peelable." This makes it possible to employ a polyethylene cover or release film for protection of the dry photopolymer film thereby to facilitate handling thereof. The polyethylene film is easily removed because of the differential adhesion of the photopolymer resist material to the polyester support web versus polyethylene. Reference to Fig. 3 shows such a polyethylene cover film 38 being peeled from the feed roll 30 of photopolymer resist 26 and wound up on a polyethylene take-up roll 40.

Positioned above the stationary platen 36 is a vertically movable heated platen 42 having an elasto meric pad element 44 affixed thereto. The structure and characteristics of the pad element 44 may be identical to those of those described hereinbefore for the pad element 12 of Fig. 1. Element 44 provides a contacting surface region 46 for contacting the surface of the carrier web 28 and is backed by the adjacent rigid surface of the heated platen 42. The shape and size of the contacting surface 46 corresponds to the shape and size of the area of dry film of polymeric material 26 that is to be affixed to the surface of the printed circuit board 34.

The heated platen 42 is movable between an "Up" position, as shown in Figs. 3 and 7, and a "Down" position, as shown in Fig. 5, by motive means 48. The motive means 48 per se forms no part of the present invention, and therefore, will not further be described herein.

When moved from the "Up" position to the "Down" position, as shown in Fig. 5, with the area 26 of dry film of polymeric material positioned as shown in Fig. 2 beneath the contacting surface 46 of pad element 44, the pad element 44 presses the carrier web 28 and thereby the area 26 of polymeric material against the adjacent surface of the printed circuit board 34. This affixes the area 26 polymeric material to the surface of the printed circuit board 34. At the end of a suitable time interval, the heated platen is moved by the motive means 48 to the "Up" position, as shown in Fig. 7. The absence of the area 26 in Fig. 6 indicates that the area 26 has been attached or laminated to the surface of the printed circuit board 34 as a mask.

While the heated platen 42 is held in the "Up" position, as shown in Fig. 7, the carrier web 28 is wound up on the take-up roll 32. This movement peels the carrier web 28 away from the area 26 of dry film of polymeric material and from the surface of the printed circuit board. Such movement also brings the next successive area 26 of dry film of polymeric material into proper alignment with the elastomeric pad element 44 for attaching such an area 26 of dry film on the next printed circuit board 34. Meanwhile, the printed circuit board 34 upon which a dry film of polymeric material had been applied, is replaced with the next printed circuit board 34. This sets the stage for the beginning of another cycle, as illustrated in Fig. 3.

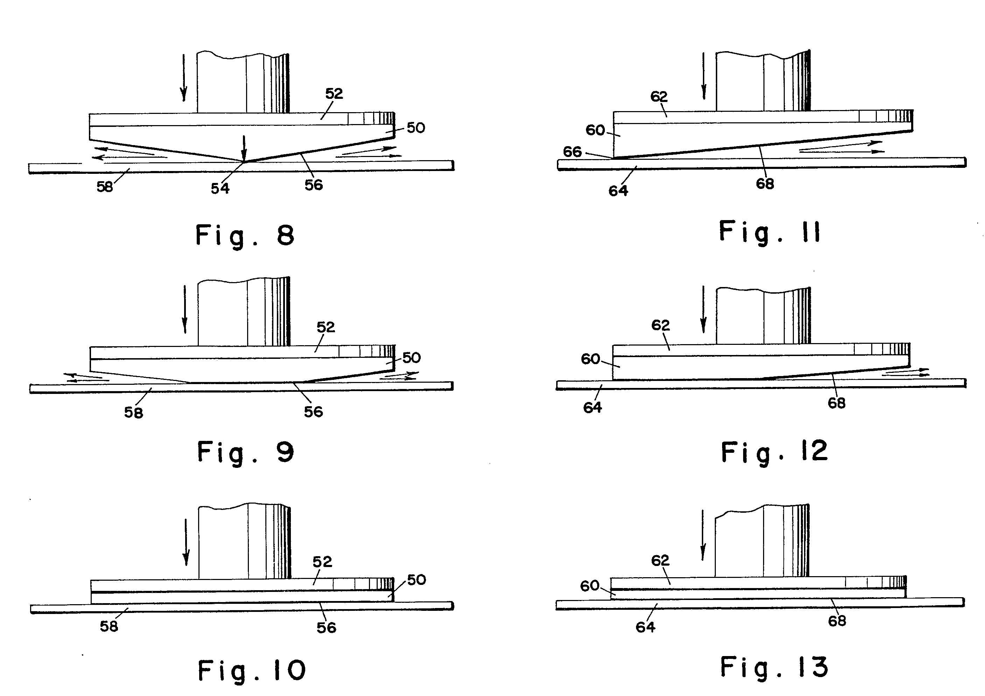

A modified form of the elastomeric pad elements 14 of Fig. 1 and 44 of Figs. 3, 5 and 7 is shown in Figs. 8, 9 and 10. Thus, as best seen in Fig. 8, this modified elastomeric pad element, designated by reference numeral 50, is normally pyramidical in shape when relaxed, that is, not subjected to mechanical pressure. Pad element 50 is provided with a rigid aluminum backing 52, and includes a centrally positioned apex 54 on a contacting surface 56 thereof. The material and density of the pad element 50 may be the same as that of the element 12 of Fig. 1. Upon movement of the pad element 50 toward the adjacent surface of a printed circuit board 58, the apex 54 makes the initial contact therewith with the area of contact of the contacting surface 56 increasing at a constant rate until the contacting surface 56 of the pad element 50 in contact with the surface of the printed circuit board is parallel therewith, as shown in Fig. 10. With the pyramidical configuration, air is squeezed out from between the contacting surface 56 of pad element 50 and the surface of the printed circuit board 58, as illustrated in Figs. 8 and 9.

When laminating a dry film of protective material (not shown in Figs. 8, 9 and 10) to the surface of the printed circuit board 58, the elastomeric pad element 50, with the apex 54 enabling initial single point contact with the surface of board 58, provides a solution for the problem of air entrapment between such film of protective material and the surface of the board 58 that would otherwise tend to occur. That is to say, the configuration of the pad element 50 providing initial single point contact with the surface of the printed circuit board 58 causes the establishment of a pressure wave which pushes air out from between the film of protective material and the surface of the printed circuit board and precludes the entrapment of such air therebetween.

Another modified form of the elastomeric pad elements 14 of Fig. 1 and 44 of Figs. 3, 5, and 7 is shown in Figs. 11, 12 and 13. This modified elastomeric pad element, designated by reference numeral 60, is normally wedge shaped when not under mechanical pressure, as shown in Fig. 11, and is provided with a rigid aluminum backing member 62. Pad element 60 is so positioned with respect to the adjacent surface of a printed circuit board 64 that upon movement of the pad element 60 toward the board 64 the initial contact therewith is a single line contact along an edge 66 of the contacting surface 68 of pad element 60. With continued movement of the pad element 60 toward the printed circuit board 64, as shown in Fig. 12, the area of contact increases at a constant rate until the contacting surface 68 in contact with the surface of the printed circuit board is parallel therewith, as shown in Fig. 13. As with the first mentioned modified form of elastomeric pad element 50, this establishes a pressure wave that pushes air out from between the contacting surface 68 and the surface of the printed circuit board 64. This is effective to prevent the entrapment of air between a dry film of protective material (not shown in Figs. 11-13) and the sur face of the printed circuit board to which such protective material is being applied.

The pressing or stamping of each of the elastomeric pad elements 12, 50 and 60 of Figs. 1, 8 and 11 may be effected under a slight vacuum to enhance conformance and to remove any entrapped air bubbles.

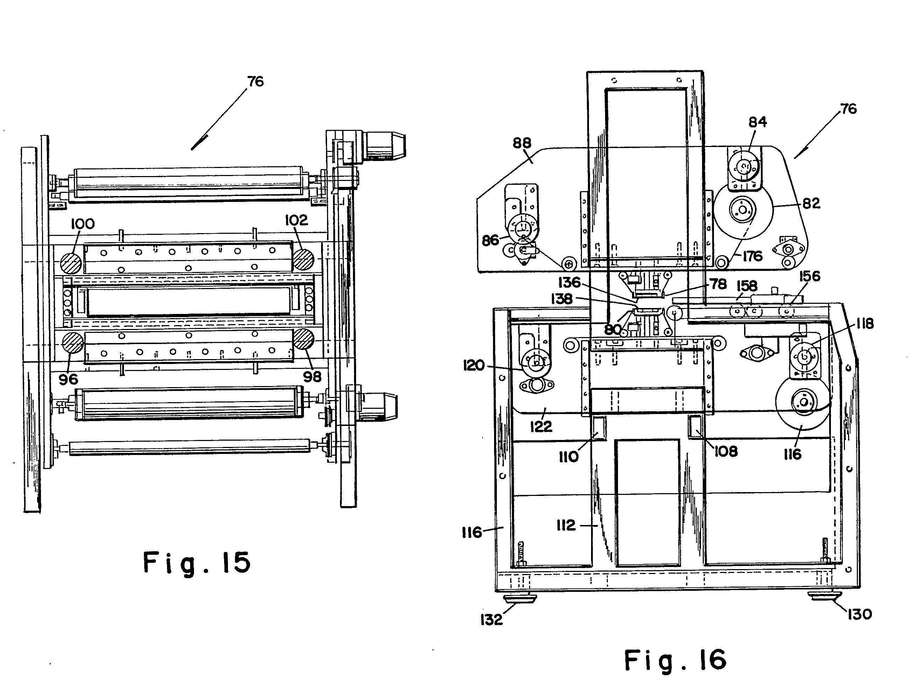

The excellent conformation of a dry film of photopolymer resist to the surface of a printed circuit board when laminated thereto using the process of the invention and employing the principles described in connection with the elastomeric pad elements 12, 50 and 60 is illustrated in Fig. 14. In Fig. 14 the reference numeral 70 designates the surface of the printed circuit board substrate, the numeral 72 designates the raised conductive circuit paths formed on the surface of the substrate 70, and the numeral 74 designates the protective film of photopolymeric material.

An embodiment of the invention for affixing a curable dry film of polymeric or heat sensitive material to both sides of a printed circuit board, portions or zones of which are to be protected, is illustrated and described herein with reference to Figs. 15, 16, 17 and 18. These figures comprise, respectively, top, right side, front and left side views of an automatically operable laminator 76 for hot stamping or pressing a predetermined area of a film of polymeric or heat sensitive material on selected areas or zones of the surfaces on both sides of each of a succession of printed circuit boards.

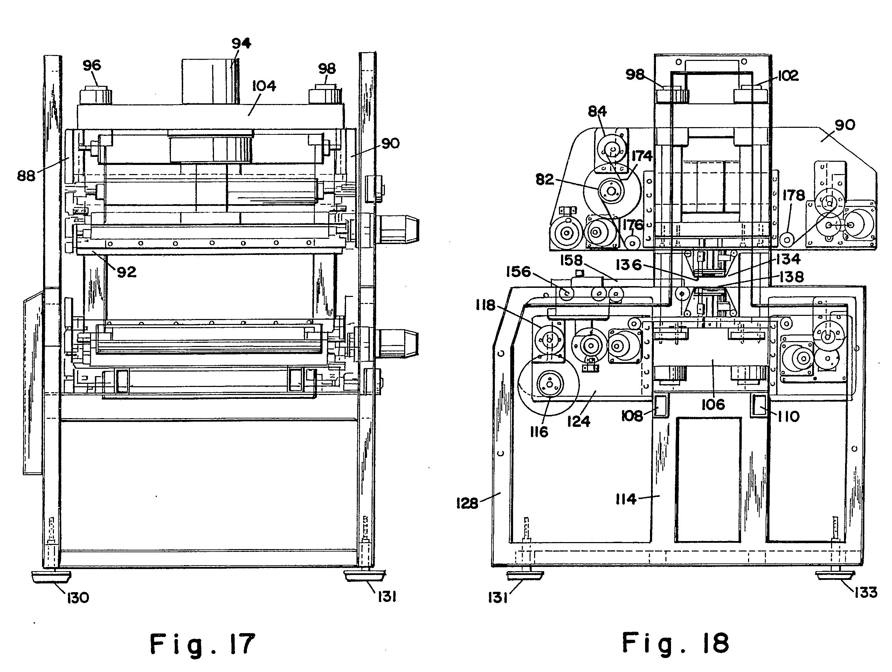

The laminator 76 includes an upper heated platen 78 and a lower heated platen 80. Associated with the upper heated platen 78 are photopolymer dry film supply roll 82, a polyethylene take-up roll 84, and a polyester take-up roll 86. Rolls 82, 84 and 86 are suitably supported for rotation between spaced parallel, vertically positioned, side plates 88 and 90, as best seen in Figs. 16 and 18. Plates 88 and 90, in turn, are fixedly attached to the opposite ends of a bolster 92 as best seen in Fig. 17, forming a box-like structure. The upper heated platen 78 is attached to and depends from the bolster 92. The bolster 92, for convenience termed an intermediate bolster hereinafter, is supported by a double acting hydraulic cylinder 94 and is guided for vertical sliding movement on four parallel bolts or rods 96, 98, 100 and 102 to the upper ends of which the cylinder 94 is fixedly attached by an upper bolster 104. The lower ends of the bolts 96, 98, 100 and 102 are fixedly attached to the lower bolster 106. Bolster 106 rests on parallel spaced beams 108 and 110 that, in turn, are supported at the ends thereof on upwardly extending frame members 112 and 114 on the left side and right side, respectively, of the laminator 76.

Associated with the lower heated platen 80 are a photopolymer dry film supply roll 116, a polyethylene take-up roll 118 and a polyester take-up roll 120. Rolls 116, 118 and 120 are suitably supported for rotation between spaced parallel, vertically positioned, lower side plates 122 and 124, as best seen in Figs. 16 and 18. Plates 122 and 124 are fixedly attached to the ends of the lower bolster 106, as shown in Fig. 18. As there shown, also, the lower heated platen 80 is positioned on and supported by the bolster 106.

The upwardly extending frame member 112, as shown in Fig. 16, forms an integral part of an upwardly extending frame 126 that defines the left side of the laminator 76. Similarly, the upwardly extending frame member 114 forms an integral part of an upwardly extending frame member 128 that defines the right side of the laminator 76, as shown in Fig. 18.

Adjustable feet 130, 131 and 132, 133 are provided on the bottoms of the frame members 126 and 128, respectively, for levelling the laminator 76.

With this structure, as described, upon downward actuation of the double acting hydraulic cylinder 94, the intermediate bolster 92 and the attached side plates 88 and 90 and the upper heated platen 78 are moved downwardly a predetermined distance. The distance moved is just sufficient to place an elastomeric pad element 136 that is carried in a downwardly depending manner by the upper heated platen 78 into a laminating, that is, a stamping or pressing region 134 for affixing a film of protective material to the upper surface of a printed circuit board positioned in the region 134.

Upon such downward movement of the hydraulic cylinder 94 and the upper heated platen 78, the lower heated platen 80 and an upwardly positioned elastomeric pad element 138 carried thereby remain relatively stationary. This is because the lower heated platen 80 is positioned on and supported by the lower bolster 106 which, in turn, is fixedly attached to the lower ends of the bolts 96-102 to the upper ends of which the hydraulic cylinder 94 is attached.

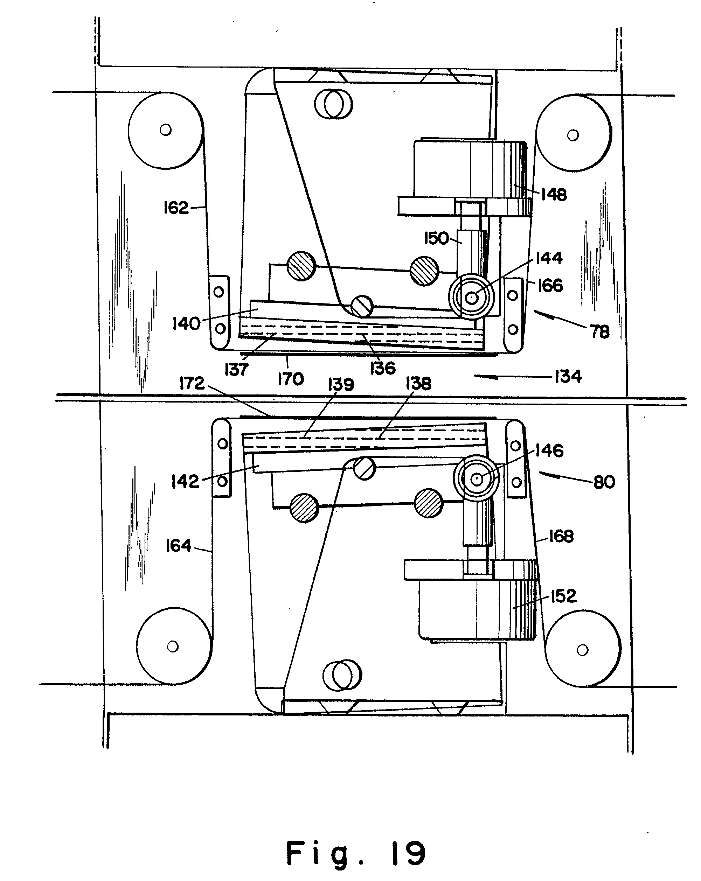

As illustrated in Fig. 19 which shows the upper heated platen 78 and the lower heated platen 80 in greater detail, the upper heated platen 78 includes a rigid backing member 140 for the elastomeric pad 136. Similarly, the lower heated platen 80 includes a rigid backing member 142 for the elastomeric pad 138. The elastomeric pads 136 and 138 desirably are provided with electrically energized heating elements designated 137 and 139, respectively.

Similarly to the elastomeric pad element 12 of Fig. 1, the cross section of the elastomeric pad elements 136 and 138 when relaxed or not under mechanically applied pressure is rectangular. The support structure for the elastomeric pad elements 136 and 138 is such, however, that the initial contact of each of the pad elements 136 and 138 with a protective film to be applied to each of the opposite sides of a printed circuit board is a single line contact, specifically of adjacent right hand edges of the pad elements 136 and 138, as seen in the drawings. Thereafter, in each case, the area of contact increases at a constant rate until the contacting surface of each elastomeric pad 136 and 138 is parallel to the individually associated surface of the printed circuit board.

To that end, as shown in Fig. 19, the backing member 140 for pad element 136 is pivoted for rotation on a pivot member 144 and the pad element 138 is pivoted for rotation on a pivot member 146. Backing member 140 for pad element 136 is biased in a clockwise direction by an adjustable air spring 148 that is connected by a link 150 to the right end thereof. Similarly, the backing element 142 is biased for rotation in a counterclockwise direction by an adjustable air spring 152.

With this structure, upon actuation of the hydraulic cylinder 94 downwardly and resulting movement of the heated platen 87 toward a printed circuit board in the laminating region 134, the initial single line contact of the lower right edge of heated pad element 136 presses an upper protective film in the stamping region 134 against the adjacent upper surface of the printed circuit board and tacks it thereto. With the hydraulic cylinder 94 continuing to exert downward force on the upper heated platen 78, a reactive upward force is exerted on the lower heated platen 80 by way of the bolts 96-102. This reactive upward force presses the upper right edge of the heated elastomeric pad 138 and a lower protective film in the region 134 into initial single line contact with the lower side of the printed circuit board and tacks the film thereto.

During this operation, the air springs 148 and 152 function to maintain the single line contact of the right end edges of the pad elements 136 and 138 with the opposite sides of the printed circuit board while the pressure applied by the hydraulic cylinder 94 is allowed to increase to a predetermined high level depending upon the adjustments of the air springs 148 and 152. Upon the attainment of such pressure level, each of the pad elements 136 and 138 is rotated very rapidly in counterclockwise and clockwise directions, respectively, thereby resulting in full contact of the contacting surface thereof with the adjacent surface of the printed circuit board. This establishes a pressure wave which pushes the air out from between the upper and lower protective films and the corresponding side of the printed circuit board and effects a quick pressing or stamping of each of the protective films into close conforming engagement with the side of the printed circuit board associated therewith.

Upon completion of the lamination operation the double acting hydraulic cylinder is actuated to raise the upper platen 78 out of the stamping or pressing region 134, thus relieving the laminating pressure that had been applied to the upper and lower surfaces of the printed circuit board.

The laminator 76, as shown in Fig. 16, includes a belt conveyor 156 for moving each of a plurality of printed circuit boards 158 in succession into the stamping or pressure region 134 between the upper platen 78 and the lower platen 80. Each of the printed circuit boards 158, of which one only is seen in the drawings, is centered as it is moved into the region 134. The means for centering the circuit boards are not shown inasmuch as such means are known and form no part of the present invention.

As each of the succession of printed circuit boards 158 is conveyed into the pressing or stamping region 134, a gripper (not shown) grabs the leading edge of the board 158 and holds it immobile during the pressing or stamping of protective films to the opposite surfaces thereof. After the stamping operation, the printed circuit board 158 is indexed forward for subsequent stamping or pressing operations or removal to a cure station, for example, an ultraviolet station or an infrared station.

As best seen in Fig. 19, an upper film 162 of dry film of photopolymer material is associated with the upper heated platen 78 for applying a protective film to the upper surface of the printed circuit board 158. A similar lower film 164 of dry film of photopolymer material is associated with the lower heated platen 80 for applying a protective film to the lower surface of the printed circuit board 158.

Each of the films 162 and 164 includes a respectively associated carrier web of polyester 166 and 168. Formed on the carrier webs 166 and 168 are respectively associated uniformly spaced areas or islands 170 and 172 of a dry film of photoresist material, all of which areas may be of the same material and size as described hereinbefore in connection with Figs. 2-7.

As the upper film 162 is unwound from the photopolymer supply roll 82, a polyethylene cover film 174 thereon is peeled off and wound up on the polyethylene take-up roll 84. The carrier web 176 of polyester with the uniformly spaced areas 170 of photoresist facing downwardly is passed over guide rolls 176, wrapped down and around the heated platen and the elastomeric pad 136, and passed over guide rolls 178 to the polyester take-up roll 86 where it is wound up.

Similarly, as the lower film 164 is unwound from the supply roll 116, a polyethylene cover film is peeled off and wound up on the polyethylene take-up roll 118. The carrier web 168 of polyester with the uniformly spaced areas 172 of photoresist facing upwardly is passed over guide rolls 182, wrapped up and around the heated platen 80 and the elastomeric pad 138, and passed over guide rolls 184 to the polyester take-up roll 120 where it is wound up.

In the operation of this embodiment of the invention, a printed circuit board 158, the upper and lower surfaces of which are to be protected, is conveyed by the belt conveyor into the stamping or pressing region 134 of the laminator 76 where the leading edge of the printed circuit board 158 is gripped by a gripper. The carrier webs 166 and 168 are then advanced to bring a respectively associated area 170 and 172 of dry film photoresist into the pressing or stamping region 134 in proper alignment with the portion or zone on the upper and lower surfaces, respectively, of the circuit board 168 that are to be protected.

When so positioned in the region 134 in operative relation with the upper and lower heated platens respectively, the areas 170 and 172 of photoresist and the respectively associated carrier webs 166 and 168 are held in suitably spaced relation therewith thereby to avoid physical contact and premature heating until the double acting hydraulic cylinder 94 is cycled into action. The operation of the cylinder 94 in moving the upper platen 78 from the raised position thereof, as seen in the drawings, to the lower laminating position and back to the raised position upon completion of the lamination operation may be in one continuous cycle.

Two modes of operation are contemplated for the laminator 76. According to a first mode, the carrier webs 166 and 168 are advanced to bring areas 170 and 172 of dry photoresist into proper alignment for application to a printed circuit board once only for each circuit board to which a protective film is to be applied. That is to say, upon application of the film to each side of a printed circuit board 158, the board 158 is removed from the laminator 76 for curing, plating, stripping, etc. at another location.

According to a second mode, it is contemplated that the carrier webs 166 and 168 may be advanced more than once, and several times, if desired, for each printed circuit board to which protective films are to be applied. Thus, after a protective film has been applied to first portions or zones on the opposite sides of a printed circuit board 158, the board 158 may be indexed forward to bring additional portions thereof to be protected into the laminating region 134 for the stamping thereon of protective films. The carrier webs 166 and 168 may be advanced simultaneously to bring respectively associated areas 170 and 172 of photoresist into alignment with such additional portions of the board 158 that are to be protected.

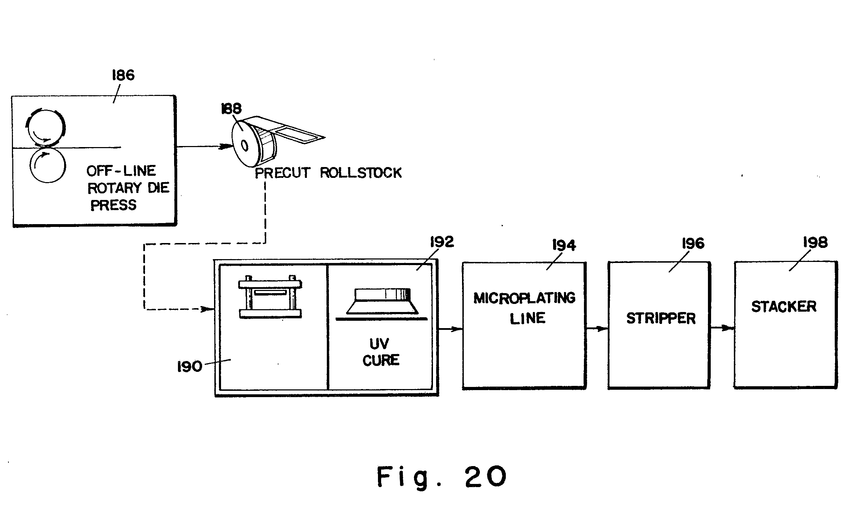

Fig. 20 illustrates a system of machine stations that may be employed in the utilization of the present invention in the fabrication of printed circuit boards or semiconductor wafers (hereinafter referred to as "components"). In Fig. 20 the numeral 186 designates an off-line rotary die press for providing pre-cut roll stock 188 on which, for example, uniformly spaced curable dry film areas of photopolymer resist are sandwiched between a polyethylene release or cover sheet and a polyester carrier web, as described hereinbefore. The pre-cut roll stock is utilized in an automatic laminator 190 which may be identical to the laminator 76 of Figs. 15-19 hereof.

From the laminator 190 the components to each of which a protective film of resist has been applied are advanced to an ultraviolet cure station 192 for curing the resist and thereby hardening it. This enables the resist to withstand the chemical solutions in the plating baths to which it is exposed during subsequent plating operations of the components.

After a suitable cure period, the components are moved to a plating machine 194 which may comprise a microplating line.

Upon completion of the plating, the components are moved to a stripping machine 196 which chemically strips the resist from the components. It is noted that this stripping is an aqueous processable operation when the resist employed is the aforesaid LAMINAR dry film photopolymer.

From the stripping machine 196 the components are moved on to a stacker 198.

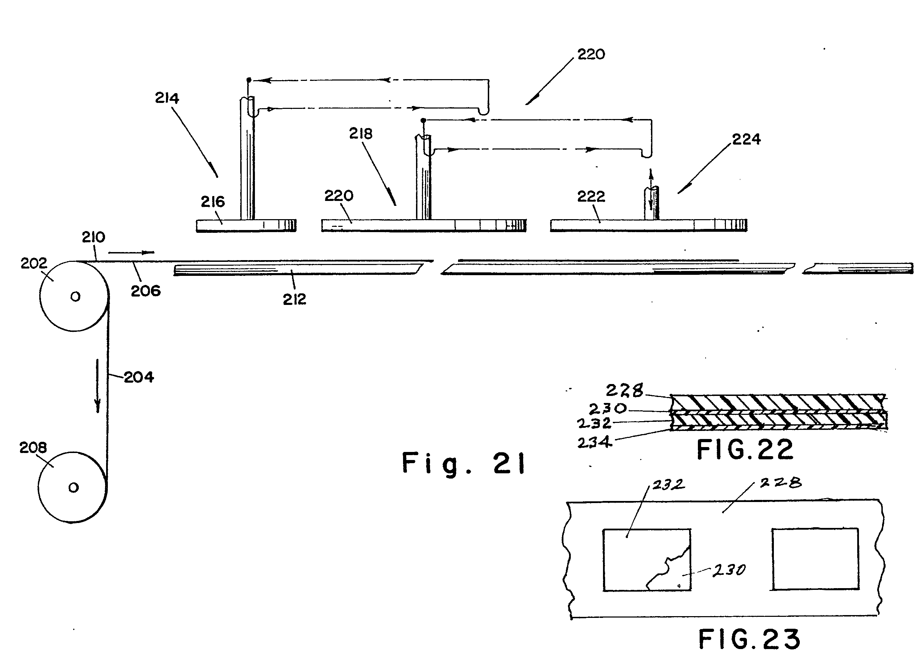

Fig. 21 is a schematic illustration of an alternative form of laminating apparatus, designated by numeral 200, that may be employed for practicing the process according to the present invention and involving the use of a hot elastomeric pad for stamping or pressing a curable dry film of polymeric or heat sensitive material to specific surface areas of a plurality of components in succession, which surface areas are to be protected from stripping and plating operations during the fabrication thereof.

The laminating apparatus 200 shown in Fig. 21 includes a supply roll 202 of dry film of polymeric material which may desirably comprise the aforementioned LAMINAR dry film photopolymer resist including a polyethylene cover film 204 and a polyester carrier or support web 206. As shown, the polyethylene cover film 204 is peeled off the supply roll and wound up on a polyethylene take-up roll 208. The polyester carrier web 206 with a dry film or photopolymer resist material 210 on the upper surface thereof is directed through a shallow elongated trough 212 which guides the carrier web 206 with the resist thereon to a first vacuum pick-up station 214 where a vacuum head 216 picks up and positions the dry film resist 210 for cutting to a length suitable for application to the surface of a component to be protected. The cut length of dry film resist 210 is positioned by vacuum head 216 in the trough 212 at a second pick-up station 218. At the pick-up station 218 a pick-up head 220 picks up the cut length dry film resist 210 and positions it on a surface portion or zone of a component to be protected, tacking it in place by using heat and pressure at the leading and trailing ends thereof. The component is then indexed under a high pressure heated head 222 which comprises a high pressure lamination station 224. The polyester carrier web 206 continues on through the trough 212 and is wound up on a polyester take-up roll.

Thus, in accordance with the invention, there has been provided improved methods of and apparatus for efficiently applying a dry film of polymeric or heat sensitive material to a specific area or specific areas of each of the surfaces of a plurality of components to provide protection from plating and stripping operations during the fabrication thereof, which methods and apparatus are characterized by an absence of any need to employ hazardous chemicals. The invention utilizes a hot elastomeric pad backed by a rigid surface for stamping and/or pressing the dry film of protective material to the surface of each of a plurality of components in succession, and is characterized in its provision for initial single point or single line contact of the elastomeric contacting surface with the surface of the component for preventing air entrapment between the dry film resist and the surface of the component. The invention is further characterized in its provisions for providing greater conformity of the protective film to the surface of the substrate.

For enhancing uniformity in the thickness or distribution of the coating of curable film over the surfaces of the raised electrically conductive circuit paths of a printed circuit board while providing excellent conformation for tab and connecting finger plating operations, it is preferred, in the practice of the methods and apparatus of the present invention, to use in association with the curable dry film a so-called "top coat," as disclosed and claimed for use in the formation of a hard permanent solder mask in application Serial No. 160,895, filed February 26, 1988 by Leo Roos, Frederick J. Axon and James B. Briguglio, the disclosure of which application by reference is made a part hereof. The Roos et al. invention and application are assigned to the assignee of the present invention. More specifically, it is preferred to use a dry film that is available commercially under the trademark "Conformask" 1000 from the Dynachem Division of Morton Thiokol, Inc., which dry film is modified by the addition of such a top coat to the film or layer of photopolymer resist.

The modified dry film, which has been designated by the reference numeral 226 in Fig. 22, includes a carrier web or cover sheet 228 of flexible, but generally non-conforming material, typically a polyester such as polyethylene terephthalate. Similarly to the carrier web 28 of Fig. 2 with which it may be identical, the carrier web 228 gives the dry film shape while allowing it to be rolled into a reel. A thin layer of material forming the top coat 230 is provided on one surface of the carrier web 228. A curable dry film 232 of photopolymer resist forms a layer on the other surface of the top coat 230. Such layer of curable dry film 232 and associated layer of top coat 230, in accordance with the invention, preferably is formed, as illustrated in Fig. 23, on the surface of the carrier web 228 along the length of the latter as a succession of uniformly spaced pieces, islands or areas similarly to the areas 26 of Fig. 2 previously described herein. A removable polyethylene cover or release film 234 covers the top coat 230 and curable dry film 232, extending the full length of the carrier web 228, and provides protection for the curable dry film 232.

The material which is used to form the top coat 230 is selectively adherent to the dry film 232 relative to the adherence thereof to the carrier web 228, whereby the carrier web 228 may be removed from the top coat 230, leaving the top coat 230 as a protective covering, and carrier support, also, for the curable dry film 232. The top coat 230 may have a thickness of about 1 micron to 12 microns, typically between 2 microns and 5 microns. When used with a polyethylene terephthalate carrier web 228 and a curable dry film 232 which is developable in aqueous or alkaline aqueous developer, it is preferred to use a material for the top coat 230 consisting essentially of (a) between about 10 weight percent and 100 weight percent of a copolymer formed by the copolymerization of between about 95 and about 99 molar percent of polyvinyl acetate and between about 1 and about 5 molar percent of alkyl ester of acrylic acid and being hydrolyzed to at least about 75%; (b) up to about 90 weight percent of hydroxyethyl cellulose; and (c) up to about 10 weight percent of plasticizer. The above described copolymers are sold under the trade designation VINOL-118M by Air Products, and 4 weight percent solutions of these copolymers have viscosities ranging from about 5 to about 65 centipoise at 20°C.

A plasticizer, if used, tends to lower the tack temperature of the top coat material. Tack temperatures below about 100°C. have been achieved using plasticizers. A top coat composition having a lower tack temperature is easier to adhere to the curable dry film 232. Preferred plasticizers are low molecular weight compounds, e.g., below about 200, having two or more hydroxyl groups, such as glycerine, ethylene glycol and propylene glycol. While plasticizers desirably lower the tack temperature, they also increase oxygen permeability of the top coat; accordingly, amounts of plasticizers in excess of about 10% by weight are desirably avoided.

The method of forming the dry film 226 is according to known procedures. The top coat and curable film or photoresist layers may be successively applied to the carrier web by methods, such as roller coating or by spraying solutions or dispersions of the materials.

The modified dry film 226 is especially advantageous for use in the application, as by pressing or stamping by means of a hot elastomeric pad, of a uniformly thick curable dry film to a surface or specific portion thereof, particularly an uneven or irregular surface due to circuit traces thereon, of each of a plurality of printed circuit boards, which surface, in each case, is to be protected from the stripping and plating operations that are involved in the fabrication of printed circuit boards.

The manner of affixing the curable dry film 232 to a portion or zone of a printed circuit board to be protected may be as illustrated hereinbefore in connection with the pressing or stamping a curable dry film to a selected surface area of a circuit board except that the carrier web 228 is removed prior to moving the curable dry film 232 between the elastomeric pad and the printed circuit board to which the curable dry film 232 is to be applied, for example, the elastomeric pad 46 and board 34 of Figs. 3, 5 and 7 or the elastomeric pad 136 and a printed circuit board positioned in the region 134 in Fig. 18. As a consequence, the elastomeric pad, in each case, contacts the top coat 230 in effecting the pressing of the curable dry film 232 to the surface of the circuit board, the top coat 230 comprising, as mentioned, a thin layer that conforms much better to the surface irregularities of the circuit board than does the polyester carrier web 228.

The material of the top coat 230 is characterized by the transparency thereof to allow the curable dry film 232 to be exposed to the U.V. light therethrough. It is also selected for its strength and flexibility. As a consequence, in the pressing operation by the elastomeric pad of the curable dry film to the surface of the board excellent conformance of the curable dry film 232 to the uneven surface of the board is achieved, with greater uniformity in thickness of the film 232 over the circuit traces of connecting tabs or fingers. It has been found, additionally, that such conformance and greater uiformity in the thickness can be achieved utilizing the modified dry film with the application of significantly lower pressure to the elastomeric pad. This avoids a problem where pressing or stamping of the curable dry film, particularly under high pressure, tends to cause the curable dry film 232 to flow and thin out, undesirably, from between the upper surface portions or high spots of the circuit traces and the elastomeric pad or other stamping device.

The use of pressing or stamping utilizing lower pressure is further advantageous in that this avoids another problem encountered with pressing or stamping at higher pressures, specifically the punching of the curable dry film through holes that are present in the printed circuit board, including plated through holes, which tends to result in tearing of the curable dry film and exposure of the copper.

Because of the greater uniformity in thickness thereof, particularly the resulting thicker layer thereof at the upper portions of the circuit traces, the curable dry film 232 is better able to withstand without being rubbed off the scrubbing required to remove scum from the fingers and any little burrs or rough spots.

The top coat 230 is formed of a material that desirably is selected for oxygen-impermeability, whereby protection is provided for the underlying layer of curable dry film 232 from oxygen inhibition during free radical photopolymerization in the exposure step, thus avoiding a problem of oxygen interference with the process of getting the curable dry film to harden up when exposed to ultra violet light.

Advantageously, the top coat 230 is selected to be aqueously strippable so that it may readily be washed off before the printed circuit board portion which is to be plated is placed in the plating solution. The curable dry film which must withstand the plating solution may be stripped following completion of the plating operation by being placed in an aqueous alkaline solution.

## Claims

1. A process for applying a curable film (26) of polymeric material to the surface of a workpiece (34) to provide protection for the workpiece during the fabrication thereof, comprising the steps of:
(a) interposing the said film (26) of polymeric material between the surface of the workpiece to be protected and the contacting surface of an elastomeric pad (44) backed by a rigid planar surface (42),
(b) moving the elastomeric pad into contact with the film of polymeric material with the contacting surface of the elastomeric pad being so characterized that the area of initial contact is substantially less than the area of the entire contacting surface thereof with the area of contact increasing at a substantially constant rate until the contacting surface of the elastomeric pad substantially coincides with the surface of the workpiece,
whereby a pressure wave is produced that pushes air out from between the film of polymeric material and the surface of the workpiece, which air otherwise could become entrapped between the film of polymeric material and the surface of the workpiece.

2. A process as claimed in claim 1 wherein the workpiece is a printed circuit board and the polymeric material is in the form of a dry film which forms a mask on the printed circuit.

3. A process as claimed in claim 1 or claim 2 wherein the surface area to be protected includes areas of non-planar geometry.

4. A process as claimed in any preceding claim which includes the steps of:
(a) forming on a carrier web (28) a dry film of the curable polymeric material (26) having an area corresponding to the area of the workpiece to be protected, said carrier web being peelable from said dry film of polymeric material,
(b) applying the dry film of polymeric material to the surface area of the workpiece while the film is on the carrier web,and
(c) peeling the carrier web (28) away from the workpiece after the pressing step.

5. A process for producing masks on printed circuits (34) by applying a curable dry film of polymeric material (26) to the area of the printed circuit to be protected, with the area of the printed circuit to be protected involving areas of non-planar geometry, which process comprises:
(a) forming on a carrier web (28) a curable dry film (16) of polymeric material having an area corresponding to the area of the printed circuit to be protected, said carrier web being peelable from said dry film of polymeric material;
(b) applying the dry film of polymeric material to the printed circuit by conveying the printed circuit into cooperative relation with the web with the dry film of polymeric material facing the printed circuit and in alignment therewith;
(c) affixing the dry film of polymeric material to the area of the printed circuit to be protected by pressing the carrier web and dry film of polymeric material against the printed circuit by means of an elastomeric pad (44) having a surface region (46) for contacting the carrier web, wherein the surface region of the elastomeric pad is backed by a rigid planar surface (42), is soft enough and so characterized as to act similarly to an incompressible fluid to apply substantially equal pressure laterally as well as in the direction of pressure application to the entire surface of the printed circuit contacted by the dry film of polymeric material including the areas of non-planar geometry; and
(d) peeling the carrier web away from the printed circuit.

6. A process as claimed in claim 5 wherein the elastomeric material has a hardness in the range of 60 + 20 as measured by a durometer.

7. A process as claimed in claim 5 or claim 6 wherein said surface region (46) of the elastomeric pad (44) is such that the area of initial contact thereof with the carrier web and dry film of polymeric material is substantially less than the area of the entire surface region, the area of contact increasing at a substantially constant rate until said surface region substantially coincides with the area of the printed circuit to be protected,
whereby a pressure wave is produced that pushes air out from between the dry film of polymeric material and the area of the printed circuit to be protected.

8. A process claimed in any one of claims 1 to 4 or claim 7 wherein the shape of the elastomeric pad (50) when relaxed is pyramidal and the surface (56) of the elastomeric pad is so arranged with respect to the area of the workpiece (58) to be protected that the apex (54) thereof is positioned to make an initial single point contact with the film of polymeric material.

9. A process as claimed in any one claims 1 to 4 or claim 7 wherein the elastomeric pad (60) has the shape of a wedge and is so positioned with respect to the area of the workpiece to be protected that an edge (66) at a thicker portion thereof makes an initial single line contact with the carrier web and film of polymeric material.

10. A process as claimed in any one of claims 1 to 4 or claim 7 wherein the elastomeric pad (136,138) in longitudinal section, is substantially rectangular in shape, is pivoted for rotation with an edge thereof positioned to make an initial single line contact with the film (162, 164) of polymeric material, and the carrier and is spring biased for rotation in the direction tending to maintain such single line contact.

11. A process as claimed in any preceding claim including the further step of:

(e) applying laminating pressure and heat to the elastomeric pad (44) after the surface region (46) thereof and the workpiece (34) to be protected substantially coincide, thereby to affix the film (26) of polymeric material to the workpiece.

12. Apparatus for applying a curable film (26) of polymeric material such as a mask to the surface of a workpiece (34) such as a printed circuit, to provide protection for the workpiece during the fabrication thereof comprising,

an elastomeric pad (44) having a contacting surface (46), a rigid backing (42) for said elastomeric pad,

means (28,30,32) for positioning a curable film of polymeric material between said contacting surface of said elastomeric pad and the surface of the workpiece to be protected,

means (48) for moving said contacting surface of said elastomeric pad into contact with the film of polymeric material thereby to press the film of polymeric material against the surface of the workpiece to be protected,

said contacting surface (46) of said elastomeric pad being characterized in that the area of initial contact is substantially less than the area of the entire contacting surface with the area of contact increasing at a substantially constant rate as the pad is pressed against the workpiece until the contacting surface of the elastomeric pad substantially coincides with the surface of the workpiece to be protected,

whereby a pressure wave is produced that pushes air out from between the film of polymeric material and the surface of the workpiece, which air otherwise could become entrapped between the film of polymeric material and the surface of the workpiece.

13. Apparatus as claimed in claim 12 further comprising:

means forming on a carrier web (28) a plurality of uniformly spaced curable dry films (26) of polymeric material of the same size with each dry film having an area corresponding to the surface area of the workpiece to be protected, said carrier web being peelable from said dry films of polymeric material, and

means (30,32) for positioning said carrier web (28) with one of said films of polymeric material formed thereon between said contacting surface of said elastomeric pad and the surface of a workpiece to be protected.

14. Apparatus as claimed in claim 13 further comprising means to peel the carrier web from the film of polymeric material.

15. Apparatus claimed in any one of claims 12 to 14 wherein the shape of the elastomeric pad (50) when relaxed is pyramidal with the elastomeric pad being arranged with respect to the surface area of the workpiece to which a polymeric film is to be applied such that the apex (54) thereof is positioned to make an initial single point contact with said film of polymeric material.

16. Apparatus as claimed in any one of claims 12 to 14, wherein the elastomeric pad (60) has the shape of a wedge and is so positioned with respect to the surface area of the workpiece to be protected that an edge (66) at the thicker portion makes an initial single line contact with the film of polymeric material.

17. Apparatus as claimed in any one of claims 12 to 14 wherein the elastomeric pad (136,138) in longitudinal section is substantially rectangular in shape, is pivoted for rotation with an edge thereof positioned to make an initial single line contact with said film of polymeric material (162,164),

which apparatus includes spring biasing means (148,152) tending to bias said elastomeric pad (136,138) for rotation in the direction tending to maintain such single line contact.

18. Apparatus as claimed in claim 17 wherein said spring biasing means (148,152) include an adjustable air spring.

19. Apparatus as claimed in any one of claims 12 to 18 further including means to apply laminating heat and pressure to the elastomeric pad after the contacting surface thereof substantially coincides with the surface of the workpiece to be protected to affix the film of polymeric material to the surface of the workpiece.

20. Apparatus (76) for producing masks on printed circuit boards (158) by applying a curable dry film of polymeric material (170,172) to the surface areas on both sides of the printed circuit boards to be protected, which surface areas may include areas of non-planar geometry, comprising,

first and second supply rolls (82,116) of material comprising uniformly spaced curable dry film of polymeric material of substantially the same size sandwiched between a continuous plastic cover film and a continuous polyester carrier web with the area of each dry film corresponding to the surface areas of the printed circuit board to which a mask is to be applied, said plastic cover film and said carrier web being peelable from said dry films,

first and second take-up rolls (84,118) associated, respectively, with said first and second supply rolls, with said plastic cover film peeled from material originating at said first supply roll (82) being wound on said first take-up roll (84) and with said plastic cover film peeled from material originating at said second supply roll (116) being wound on said second take-up roll (118),

third and fourth take-up rolls (86,120) associated, respectively, with said first and second supply rolls with said carrier web (166) peeled from material originating at said first supply roll (82) being wound on said third take-up roll and with said carrier web (168) peeled from material originating at said second supply roll (116) being wound on said fourth supply roll,

a first platen (78) for pressing said carrier web and dry film of polymeric material originating at said first supply roll (82) on the surface of one of the sides of the printed circuit board,

a second platen (80) for pressing said carrier web and dry film of polymeric material originating at said second supply roll (116) on the other side of the printed circuit board,

a first support means (88,90,92) for said first supply roll, said first and third take-up rolls and said first platen,

a second support means (106,122,124) for said second supply roll, said second and fourth take-up rolls, and said second platen,

guide means (176) on said first support means for guiding said carrier web (162) and said dry film of polymeric material (170) originating at said first supply roll into co-operative relation with said first platen,

guide means on said second support means for guiding said carrier web (164) and said dry film of polymeric material (172) originating at said second supply roll into cooperative relation with said second platen,

conveying means (156) for conveying a printed circuit to be protected between said first and second platens and the respective individually associated carrier webs and dry films of polymeric material, and

means (94) to effect relative movement of said first and second support means thereby to cause said first platen to contact and press the associated said carrier web and dry film of polymeric material against said one side of the printed circuit board and to cause said second platen to contact and press the associated said carrier web and dry film of polymeric material against said other side of the printed circuit board.

21. Apparatus as claimed in claim 20 wherein the means to effect relative movement of said first and second support means is a double acting hydraulic cylinder (94), and which further includes support means comprising a first bolster (104) for supporting said hydraulic cylinder.

22. Apparatus as claimed in claim 21 wherein each of said first and second support means comprises a second and third bolster (92,106), respectively, with said first bolster (104) and said third bolster (106) being rigidly attached to each other and said second bolster (92) being movable relatively to said first and third bolsters by said hydraulic cylinder (94).

23. Apparatus as claimed in claim 22 wherein said first support means further includes spaced plates (88,90) between which said first supply roll, said first and said third take-up rolls are supported, and the second support means further includes spaced plates (122,124) between which said second supply roll, said second take-up roll and said fourth take-up roll are supported.

24. Apparatus as claimed in any one of claims 20 to 23 wherein each of said first and second platens (78,80) is heated.

25. Apparatus as claimed in any one claims 20 to 24 wherein each of said first and second platens (78,80) includes a respectively associated first and second elastomeric pad (136,138), each of which pads has a rigid backing (140,142) and is pivoted for rotation, and further including,

a first spring means (140) to bias said first elastomeric pad (136) for rotation in a clockwise direction, and

a second spring means (152) to bias said second elastomeric pad (138) for rotation in a counter-clockwise direction,

whereby upon movement of the first elastomeric pad associated with said first platen into pressing contact with said carrier web and dry film of polymer associated therewith the initial contact therewith is along a first edge thereof and upon pressing contact of the second elastomeric pad associated with said second platen into pressing contact with said carrier web and dry film of polymer associated therewith the initial contact therewith is along an edge thereof that is adjacent the said first edge of said first elastomeric pad.

26. A process for producing masks on printed circuits by applying a curable dry film of polymeric material to the area of the printed circuit to be protected, wherein the improvement comprises:

(a) forming on a carrier web a curable dry film of polymeric material having an area corresponding to the area of the printed circuit to be protected, said dry film of polymeric material being peelable from said carrier web;

(b) applying the dry film of polymeric material to the printed circuit by conveying said formed area of dry film on said carrier web beneath the printed circuit and in aligned facing relation therewith;

(c) affixing the dry film of polymeric material to the area of the printed circuit to be protected by pressing the carrier web and dry film of polymeric material against the printed circuit; and

(d) peeling the carrier web away from the printed circuit.

27. A process for producing masks on printed circuits by applying a curable dry film of polymeric material to the area of the printed circuit to be protected, with the area of the printed circuit to be protected involving areas of non-planar geometry, wherein the improvement comprises:

(a) forming on a carrier web a top coat of polymeric material characterised by the transparency, strength and flexibility thereof;

(b) forming on said top coat a curable dry film of polymeric material, said curable dry film having an area corresponding to the area of the printed circuit to be protected, said top coat having a greater adherence to said curable dry film than to said carrier web whereby said carrier web is peelable from said top coat and curable dry film;

(c) forming on said curable dry film a removable protective film;

(d) peeling said removable protective film away from said curable dry film;

(e) peeling said carrier web away from said top coat and curable dry film;

(f) applying said curable dry film of polymeric material to the printed circuit by conveying said formed area of curable dry film and said top coat in operative association to the printed circuit in aligned facing relation therewith; and

(g) affixing said curable dry film of polymeric material to the area of the printed circuit to be protected by pressing said top coat and curable dry film against the printed circuit by means of an elastomeric pad having a surface region for contacting said top coat.

28. A process as claimed in claim 27 wherein in step (g) said elastomeric pad is heated and the surface region thereof is backed by a rigid planar surface, is soft enough and so characterised as to act similarly to an incompressible fluid to apply substantially equal pressures laterally as well as in the direction of pressure application to the entire surface of the printed circuit contacted by the curable dry film of polymeric material including areas of non-planar geometry.

29. A process as defined by claim 28 wherein in step (b) said curable dry film is formed on the top coat as a succession of uniformly spaced areas each of which areas corresponds in size to the area of a printed circuit to be protected; wherein in step (e) each of the formed areas of curably dry film is applied to a printed circuit individually associated therewith by conveying each of the formed areas of curable dry film in operative association with such individually associated printed circuit, in aligned facing relation therewith; and

wherein, in step (g) each of said formed areas of curable dry film is affixed to the printed circuit individually associated therewith by pressing, in turn, each such area of curable dry film and the top coat associated therewith against such printed circuit by means of said heated elastomeric pad.

30. A process as defined by claim 29 wherein said surface region of said elastomeric pad is so characterised that the area of initial contact thereof with the top coat and said curable dry film of polymeric material is substantially less than the area of said entire surface region with area of contact increasing at a substantially constant rate until said surface region substantially coincides with the area of the printed circuit to be protected;

whereby a pressure wave is produced that pushes air out from between the dry film of polymeric material mid the area of the printed circuit to be protected.

31. A process as claimed in claim 30 wherein in step (g) the top coat and curable dry film are pressed against the printed circuit under a slight vacuum.

32. A process as claimed in claim 1 wherein the movement of the elastomeric pad into contact with the film of polymeric material and the surface of the workpiece is effected under a slight vacuum.

Fig. 1

Fig. 14

Fig. 2

POLYESTER FILM
PHOTOPOLYMER MATERIAL

Fig. 4

POLYESTER FILM
PHOTOPOLYMER MATERIAL

Fig. 6

POLYESTER FILM

Fig. 3

BEGIN OF CYCLE "UP" POSITION

Fig. 5

CYCLE "DOWN" POSITION

Fig. 7

END CYCLE "UP" POSITION

Fig. 8

Fig. 9

Fig. 10

Fig. 11

Fig. 12

Fig. 13

EP 0 324 596 A2

Fig. 15

Fig. 16

EP 0 324 596 A2

Fig. 17

Fig. 18

EP 0 324 596 A2

Fig. 19

186

OFF-LINE
ROTARY DIE
PRESS

188

PRECUT ROLLSTOCK

192

190

UV
CURE

194

MICROPLATING
LINE

196

STRIPPER

198

STACKER

Fig. 20

EP 0 324 596 A2

Fig. 21

FIG.22

FIG.23

EP 0 324 596 A2